# EUROPEAN PATENT APPLICATION

(11) **EP 2 472 573 A1**
(43) Date of publication of application: **04.07.2012**
(21) Application number: 11150120.1
(22) Date of filing: 04.01.2011
(51) Int. Cl.: H01L 21/336, H01L 29/78, H01L 29/40, H01L 29/423, H01L 29/51

(54) **Vertical transistor manufacturing method and vertical transistor**

(71) Applicant: NXP B.V., 5656 AG Eindhoven (NL)
(72) Inventor: Jin, Minghao, Redhill, Surrey RH1 1DL (GB); Calton, David William, Redhill, Surrey RH1 1DL (GB); Kershaw, Nick, Redhill, Surrey RH1 1DL (GB); Rogers, Chris, Redhill, Surrey RH1 1DL (GB)
(74) Representative: Hardingham, Christopher Mark

(57) **Abstract**

A method of manufacturing a vertical transistor comprising a substrate (100) including a vertical stack of regions including a source region (106) separated from a drain region (102) by a channel region (104); the method comprising forming a trench (110) at least partially extending into said vertical stack of regions; lining said trench with a stack comprising a gate dielectric liner (112), an etch protection layer (114) and a further insulating layer (116); filling the remainder of the trench with a shield electrode material (118); exposing a top portion of the shield electrode material by removing the further insulating layer (116) to a first depth in said trench; forming an inter electrode dielectric liner (122) on the exposed shield electrode material; removing the etch protection layer (114) to the first depth from said trench; and forming a gate electrode (124) in said trench between the inter electrode dielectric liner (122) and the exposed portion of the gate dielectric liner (112). A vertical transistor manufactured in accordance with this method is also disclosed.

## Description

### FIELD OF THE INVENTION

The present invention relates to a vertical transistor comprising a substrate including a vertical stack of regions including a source region separated from a drain region by a channel region and a trench lined with a gate dielectric liner, said trench at least partially extending through said vertical stack of regions, wherein said trench comprises a shield electrode and a gate electrode surrounding an upper portion of the shield electrode.

The present invention further relates to a method of manufacturing such a vertical transistor.

### BACKGROUND OF THE INVENTION

Vertical transistors, e.g. trench-MOS (metal oxide semiconductor) transistors are promising devices to allow for the further increase of the device density in a semiconductor chip. In order to improve the characteristics of such vertical transistors, architectures have been proposed in which in addition to the vertical gate electrode, a shield electrode is provided, as the presence of the shield electrode is known to relax the design choices that govern the tradeoff between the punch-through voltage (BV_{dss}) and the drain-source on-resistance (R_{ds-on}) of the transistor.

An example of such a vertical transistor is disclosed in US 5,126,807 and is shown in FIG. 1, which provides a sectional view of a vertical MOS transistor comprises an n⁺-type monocrystalline silicon substrate 1, a drain region 3 made of n⁻-type impurity semiconductor grown epitaxially on the substrate 1, a channel region 5 made of p-type impurity semiconductor in the drain region 3, a source region 7 made of n⁺-type impurity semiconductor on the channel region 5, a trench 23 formed through the regions 5 and 7, a shield electrode 11 disposed in the trench 23 to extend above the source region 7 with a relatively thick first gate insulation film 9 interposing between the walls of the trench 23 and the shield electrode 11, and a main gate electrode 17 formed over the shield electrode 11 approximately between the upper half of the shield electrode 11 and the wall of the trench 23 with a capacitance insulation film 13 interposing between the shield and gate electrodes 11 and 17 and with a relatively thin second gate insulation film 15 interposing between the gate electrode 17 and the channel region 5 and source region 7. The top of the first gate insulation film 9 is at the level of the drain region 3 and distanced upwardly by a distance X away from the bottom of the first gate electrode 11. The source region 7 is connected to a source electrode 19, and the gate electrode 17 is connected to a gate control electrode 21. When a positive control voltage is applied to the gate electrode 17, the source electrode 19 is electrically connected to the substrate 1 through a channel.

Another important performance parameter of such a transistor is the gate to drain coupled charges (Q_{gd}). The presence of such charges limits the switching speed of the transistor, and it is therefore important that Q_{gd} is minimized in the design of the vertical transistor. For this reason, it is important that the shield electrode is electrically insulated from the gate electrode. A problem that in particular arises when the shield electrode is implemented as a doped polysilicon electrode is that the growth of a high integrity dielectric layer and in particular an oxide layer over such a material is notoriously difficult as an oxide layer grown on a (doped) polysilicon surface has a lower field to breakdown than an oxide layer grown on a monocrystalline silicon surface.

The vertical transistor of US 5,126,807 has the drawback that the gate oxide 15 separating the gate electrode 17 from the channel region 5 is grown at the same time as the capacitance insulation film 13, such that it becomes difficult to optimize the breakdown properties, i.e. individually optimize the thicknesses of both the gate oxide 15 and the capacitance insulation film 13 as the gate oxide 15 is grown on a monocrystalline silicon surface whereas the gate oxide 15 is grown on a polycrystalline silicon surface.

Moreover, in order to facilitate the formation of the gate electrode 17, the gate oxide 9 is removed from the top portion of the trench 23 as shown in FIG .7E of US 5,126,807. This has the additional problem that upon formation of the gate oxide 15 in the top portion of the trench 23, a weak spot is formed at the interface between the gate oxide 15 and the gate oxide 9, which can cause a deterioration of the breakdown characteristics of the vertical transistor.

### SUMMARY OF THE INVENTION

The present invention seeks to provide a method of manufacturing a vertical transistor having improved breakdown characteristics.

The present invention further seeks to provide a vertical transistor having improved breakdown characteristics.

According to an aspect of the present invention, there is provided a method of manufacturing a vertical transistor comprising a substrate including a vertical stack of regions including a source region separated from a drain region by a channel region; forming a trench in said substrate, said trench at least partially extending into said vertical stack of regions; lining said trench with a stack comprising a gate dielectric, an etch protection layer and a further insulating layer; filling the remainder of the trench with a shield electrode material; exposing a top portion of the shield electrode material by removing the further insulating layer to a first depth in said trench; forming an inter electrode dielectric on the exposed shield electrode material; removing the etch protection layer to the first depth in said trench; and forming a gate electrode in said trench between the inter electrode dielectric and the exposed portion of the gate dielectric.

The present invention is based on the realization that by protecting the gate dielectric such as a gate oxide liner by an etch protection layer, the inter electrode dielectric electrically insulating the shield electrode from the gate electrode may be formed independently of the gate dielectric, such that the characteristics, e.g. respective thicknesses, of the inter electrode dielectric and the gate dielectric may be optimized separately such that the breakdown characteristics of the vertical transistor are improved. In addition, due to the fact that the gate dielectric does not have to be temporarily removed from the top portion of the trench to facilitate the formation of the inter electrode dielectric and the gate electrode, the formation of weak spots in the gate dielectric can be avoided.

In an embodiment, the etch protection layer is a nitride layer. A nitride layer such as silicon nitride (e.g. Si₃N₄) is particularly suitable to protect a gate oxide from etching as nitride is substantially inert to most oxide etching recipes. Preferably, the nitride layer is performed by means of a low pressure chemical vapor deposition step as this improves the quality of the nitride layer and is better suited to subsequent high temperature processing steps than other methods of nitride deposition.

In a preferred embodiment, the step of filling the remainder of the trench with a shield electrode material comprises filling said remainder with a polysilicon material, as the benefits of being able to separately optimize the formation of the inter electrode dielectric are most pronounced when the shield electrode is a polysilicon electrode and the substrate is a monocrystalline silicon substrate.

If the shield electrode material is polysilicon, it is preferable that the step of forming the gate electrode comprises depositing a polysilicon material in between the inter electrode dielectric and the exposed portion of the gate dielectric, as this simplifies the manufacturing process.

In a further embodiment, the method further comprises thickening the gate dielectric after the removal of the intermediate dielectric layer to the first depth in said trench. This further reduces the risk of the presence of any weak spots in the gate dielectric separating the gate electrode from the channel region.

In accordance with another aspect of the present invention, there is provided a vertical transistor comprising a substrate including a vertical stack of regions including a source region separated from a drain region by a channel region and a trench lined with a gate dielectric, said trench at least partially extending through said vertical stack of regions, wherein said trench comprises a shield electrode and a gate electrode surrounding an upper portion of the shield electrode, and being laterally separated from the upper portion by a inter electrode dielectric covering said portion, and wherein the remainder of the shield electrode is laterally separated from the gate dielectric liner by a further insulating layer and an etch protection layer between the gate dielectric and the further insulating layer.

Such a vertical transistor has improved dielectric breakdown characteristics compared to the prior art vertical transistor as weak spots in the gate dielectric have been avoided and the thickness of the inter electrode dielectric has been optimized independently of the thickness of the gate dielectric separating the gate electrode from the substrate.

Preferably, the etch protection layer is a nitride layer, and the gate dielectric is a gate oxide.

It is further preferred that at least the shield electrode comprises polysilicon for the reasons already discussed above.

The vertical transistor may advantageously be integrated into a semiconductor device such as an integrated circuit.

### BRIEF DESCRIPTION OF THE EMBODIMENTS

Embodiments of the invention are described in more detail and by way of non-limiting examples with reference to the accompanying drawings, wherein
FIG. 1 schematically depicts a prior art vertical MOS transistor;
FIG. 2-10 schematically depict various steps of an embodiment of the method of the present invention; and
FIG. 11 is a scanning electron microscope (SEM) image of a device comprising vertical transistors manufactured in accordance with an embodiment of the method of the present invention.

### DETAILED DESCRIPTION OF THE DRAWINGS

It should be understood that the Figures are merely schematic and are not drawn to scale. It should also be understood that the same reference numerals are used throughout the Figures to indicate the same or similar parts.

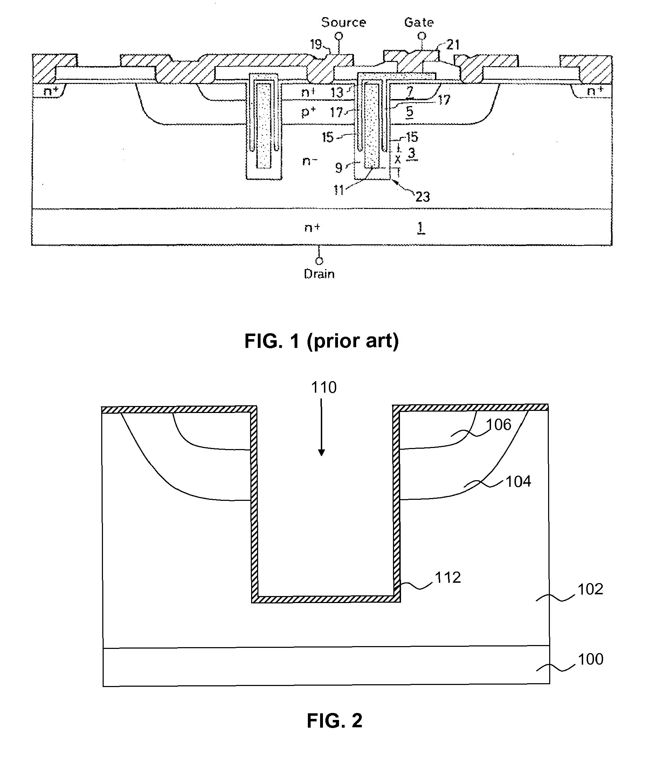

FIGS. 2-10 schematically depict the main steps of an example embodiment of the method of the present invention for manufacturing a vertical MOS transistor, also referred to as a trench MOS transistor. It will be understood that alternative realizations of the following steps may be contemplated by the skilled person without departing from the present invention.

In FIG. 2, a substrate 100 is provided that comprises a drain region 102, a channel region 104 and a source region 106. The substrate 100 preferably is a monocrystalline silicon substrate although other suitable substrate types may also be contemplated. The vertical stack of the drain region 102, channel region 104 and source region 106 may be realized in any suitable manner. As many techniques are readily available to the skilled person to realize such a vertical stack, these will not be discussed in detail for the sake of brevity. Alternatively, region 102 may be a source region and region 106 may be a drain region.

The regions 102, 104 and 106 may comprise any suitable type of impurity. For instance, the drain region 102 and the source region 106 may comprise n-type impurities and the channel region 104 may comprise a p-type impurity, in which case the substrate 100 may be an n-type silicon substrate. Alternatively, the drain region 102 and the source region 106 may comprise p-type impurities and the channel region 104 may comprise an n-type impurity, in which case the substrate 100 may be a p-type substrate or an n-type silicon substrate comprising a p-well in which the vertical transistor is formed. Other possible implementations of the substrate material and the vertical stack of source, drain and channel regions will be apparent to the skilled person.

A vertical trench 110 is formed in the substrate 100 that extends into the drain region, such that the trench 110 extends beyond the source region 106 and the channel region 104. The formation of such a trench 110 is well-known per se. For instance, a hard mask may be deposited over the substrate 100 and subsequently patterned to expose the area of the trench 110, after which an etch step is applied to form the trench 110, followed by the removal of the hard mask. The trench 110 is lined with a gate dielectric liner 112, which preferably is a gate oxide. Again, the growth of such a gate dielectric liner 112 is common practice in vertical transistor manufacture and may be realized in any suitable manner.

At this point it is noted that variations to the process shown in FIG. 2 should be immediately apparent to the skilled person. For instance, it is equally feasible to form the trench 110 prior to the formation of at least some of the impurity regions 102, 104 and 106. For instance, the channel or body region 104 and the source region 106 may be formed in the substrate 100 after formation (and filling) of the trench 110. As the formation of these impurity regions do not affect the concept of the present invention they may be realized in any suitable manner.

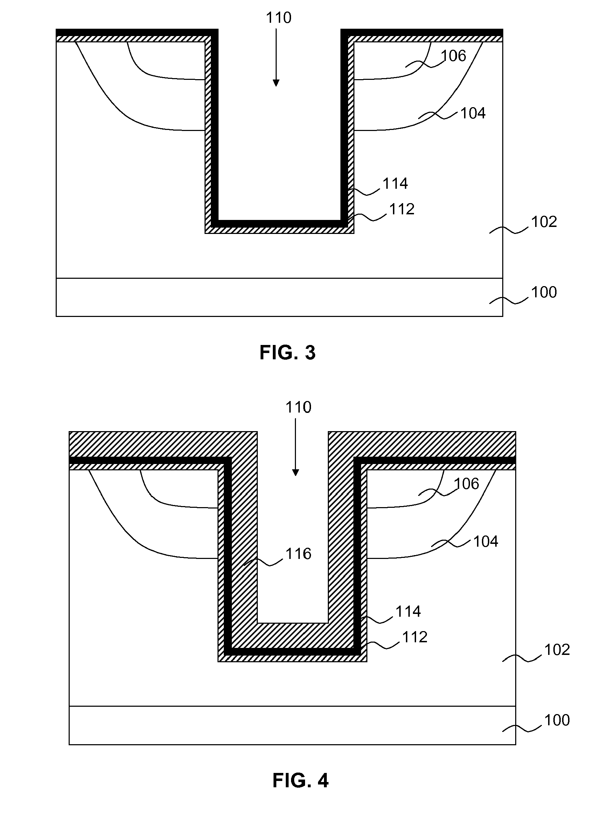

As shown in FIG. 3, the gate dielectric 112 is subsequently covered by an etch protection layer 114, which protects the gate dielectric liner 112 against being removed by an etch recipe. Etch protection layers are known per se, such that the skilled person can select a suitable material for the etch protection layer 114 based on the selection of the material for the gate dielectric liner 112. In case of the gate dielectric liner 112 being a gate oxide liner, e.g. SiO₂ or TEOS (tetraethyl orthosilicate), a suitable material for the etch protection layer 114 is silicon nitride (Si₃N₄) or another nitride-based layer. The nitride layer may be formed by a LPCVD deposition step. The thickness of the etch protection layer 114 should be sufficient to effectively protect the underlying gate dielectric 112 from damage during subsequent etching steps. Alternatively, a high-k dielectric layer may be used as an etch stop layer, which allows the equivalent electric field to be generated in a thinner gate dielectric 112 to enable further pitch shrink. Furthermore, high-k insulator materials can improve the stress and thermal criteria of the device.

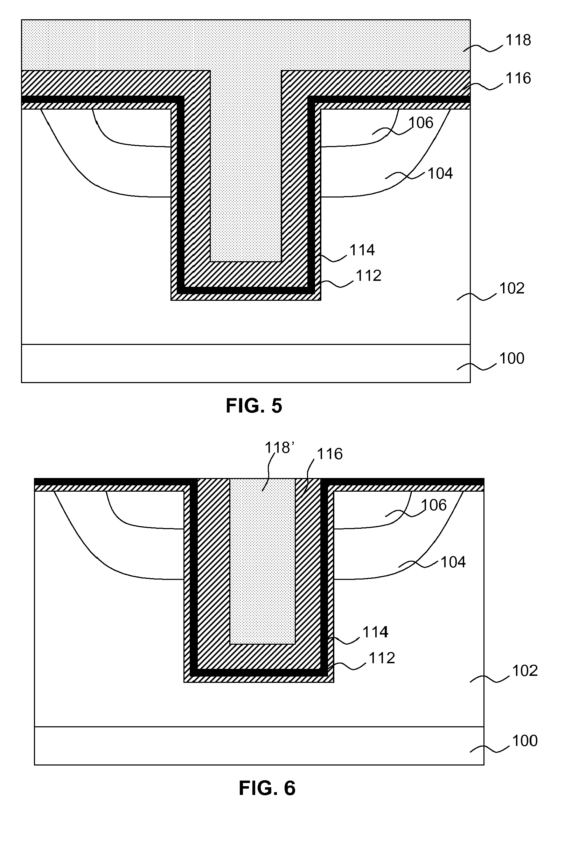

Next, as shown in FIG. 4, a further insulating layer 116 is deposited to a thickness that is sufficient to electrically insulate the shield electrode from the substrate 100 in combination with the gate dielectric 112 and the etch protection layer 114. For this reason it is preferred that the etch protection layer also is an electrically insulating layer such as a nitride layer. Any suitable material may be chosen for the further insulating layer 116, e.g. an oxide such as SiO₂ or TEOS. The remainder of the trench 110 is subsequently filled with a suitable shield electrode material 118, e.g. polycrystalline silicon or amorphous silicon, which may be (subsequently) doped to tune the electrical properties of the shield electrode. This is shown in FIG. 5.

After the deposition of the suitable shield electrode material 118, the resultant structure is planarized to remove excess material of the further insulating layer 116 and the shield electrode material 118 from the upper surface of the substrate 100, as shown in FIG. 6. The planarization may be achieved in any suitable manner, such as by etching or by polishing, e.g. chemical mechanical polishing. The etch protection layer 114 may be used as an etch stop layer for such an etching step or as a stop layer for the polishing step, in which case it is preferred that the etch protection layer 114 is a nitride layer as it is known per se that polishing processes such as CMP can be accurately terminated on a nitride layer.

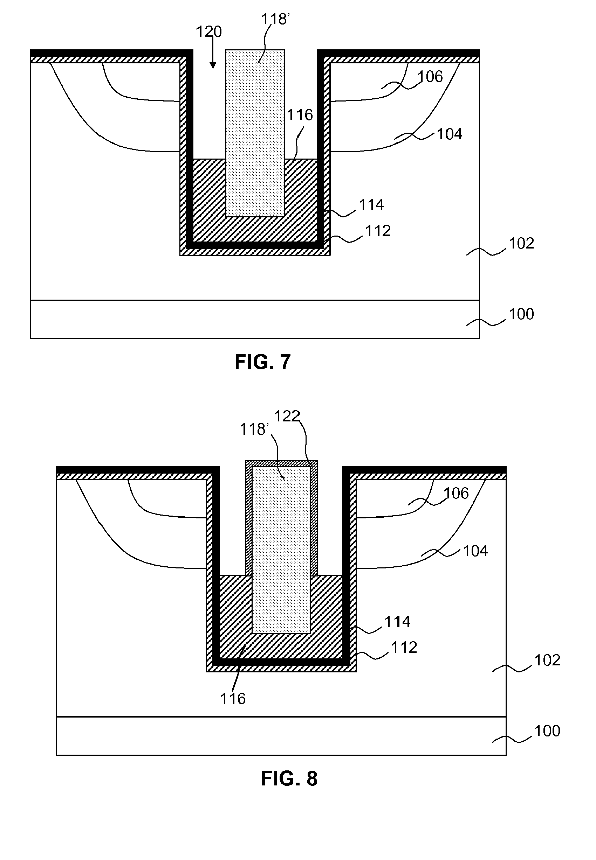

Next, as shown in FIG. 7, the further insulating layer 116 is partially removed from the trench 110, e.g. by etching, to form a recess 120 surrounding a top portion of the shield electrode 118'. The recess 120 has a depth extending to beyond the channel region 104 of the vertical transistor, as the recess 120 is to house the gate electrode of the transistor. In case of the further insulating layer 116 being an oxide layer such as SiO₂ or TEOS, a suitable oxide etch recipe may be used for this purpose. As such etch recipes are known per se, they will not be further discussed for the sake of brevity. It is pointed out that during the formation of the recess 120 by etching, the gate dielectric 112 is protected from the etch recipe by the etch protection layer 114, thereby obviating the need to reform the gate dielectric 112 at a later stage, such that defects at the interface between the originally grown gate dielectric 112 and the reformed gate dielectric 112 do not occur as no such interface is present.

An inter electrode dielectric liner 122 is subsequently grown on the exposed portion of the shield electrode 118', e.g. an oxide liner. Due to the fact that this liner is grown independently of the gate dielectric liner 112, i.e. this liner does not also have to oxidize a part of the outer wall of the trench 110 to form a gate dielectric on the outer wall, the growth conditions for the inter electrode dielectric liner 122 can be optimized without having to consider implications for the performance of the vertical transistor resulting from the properties (e.g. thickness) of the gate dielectric liner 112. This is an important improvement over the prior art device shown in FIG. 1, where the shield electrode capping oxide has the dual purpose of also forming the gate oxide in the upper portion of the trench as previously explained. This is particularly relevant if the growth conditions of the inter electrode dielectric 122 on the surfaces of the shield electrode 118' are substantially different to the growth conditions of the inter electrode dielectric 122 on the outer walls of the trench 110, i.e. on the substrate 100, which for instance is the case when growing an oxide on a polysilicon shield electrode 118', with the substrate 100 being a monocrystalline silicon substrate.

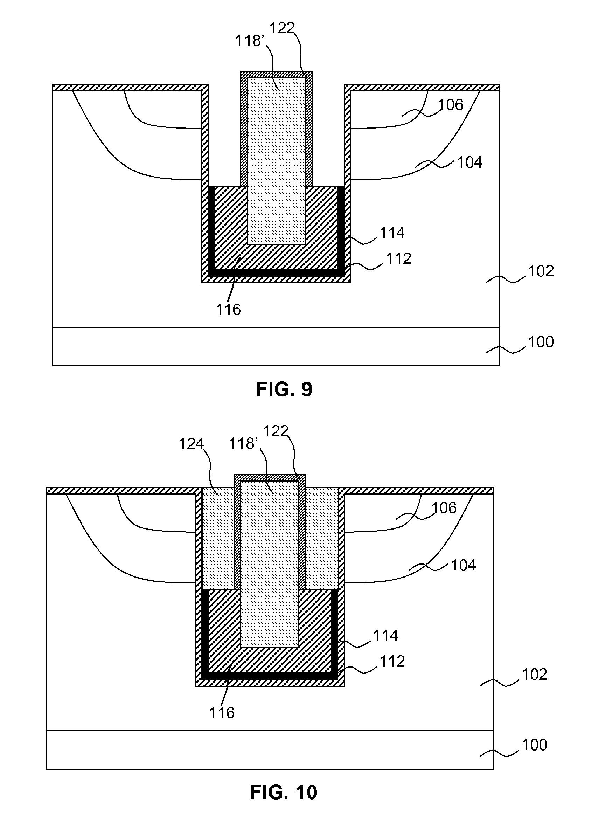

As is shown in FIG. 9, the method proceeds by removing the exposed portions of the etch protection layer 114 from the resultant structure, e.g. by means of a nitride strip in case of the etch protection layer 114 being a nitride layer. Nitride strip recipes are well-known per se and are therefore not discussed in further detail for the sake of brevity. At this point, the gate dielectric 112 exposed in the recess 120 may be thickened if necessary, e.g. to repair damage cause by the removal of the etch protection layer 114 or to tune the characteristics of the vertical transistor. This thickening step is entirely optional and maybe omitted without departing from the present invention.

The gate structure of the vertical transistor is completed as shown in FIG. 10 by the deposition of the gate electrode material 124 in the recess 120, e.g. a polysilicon or amorphous silicon material, and subsequently planarizing the resulting structure. The planarizing step has not been explicitly shown for the sake of brevity. The vertical transistor may subsequently be completed using conventional processing steps, e.g. contact forming steps, back-end metallization steps, device packaging steps and so on. The shield electrode 118' may be a floating electrode or may be tied to the source electrode (not shown).

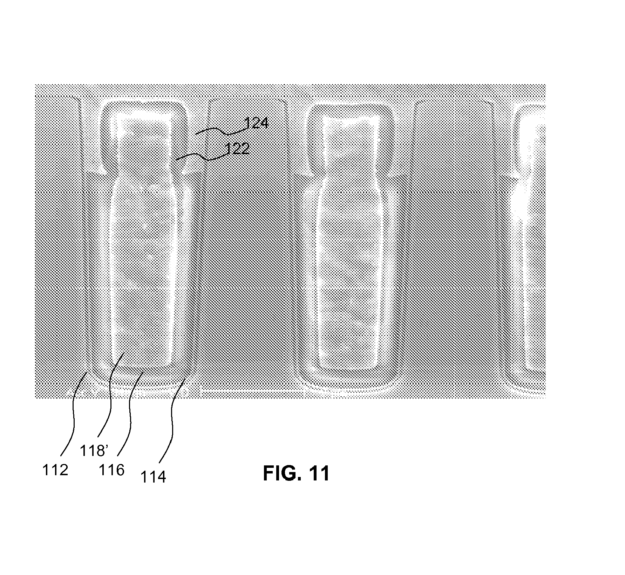

FIG. 11 shows a SEM image of a cross section of a device comprising a plurality of trench MOS transistors manufactured in accordance with an embodiment of the present invention. The vertical transistors comprise a polysilicon shield electrode 118', in which a bottom portion is separated from the monocrystalline silicon substrate by a deposited layer 116, a nitride layer 114 and a gate dielectric liner 112. The polysilicon gate electrode 124 is electrically insulated from the shield electrode 112 by an inter electrode oxide layer 122 and from the substrate by the gate dielectric liner 112.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. The word "comprising" does not exclude the presence of elements or steps other than those listed in a claim. The word "a" or "an" preceding an element does not exclude the presence of a plurality of such elements. The invention can be implemented by means of hardware comprising several distinct elements. In the device claim enumerating several means, several of these means can be embodied by one and the same item of hardware. The mere fact that certain measures are recited in mutually different dependent claims does not indicate that a combination of these measures cannot be used to advantage.

## Claims

1. A method of manufacturing a vertical transistor comprising a substrate (100) including a vertical stack of regions including a source region (106) separated from a drain region (102) by a channel region (104);
forming a trench (110) in said substrate, said trench at least partially extending into said vertical stack of regions;
lining said trench with a stack comprising a gate dielectric (112), an etch protection layer (114) and a further insulating layer (116);
filling the remainder of the trench with a shield electrode material (118); exposing a top portion of the shield electrode material by removing the further insulating layer (116) to a first depth in said trench;
forming an inter electrode dielectric (122) on the exposed shield electrode material;
removing the etch protection layer (114) to the first depth from said trench; and
forming a gate electrode (124) in said trench between the inter electrode dielectric (122) and the exposed portion of the gate dielectric (112).

2. The method of claim 1, wherein the vertical stack of regions is formed after the formation of said trench.

3. The method of claim 1 or 2, wherein the etch protection layer (114) is a nitride layer.

4. The method of claim 3, wherein the step of lining the gate dielectric (112) with the nitride layer (114) is performed by means of a low pressure chemical vapor deposition step.

5. The method of any of claims 1-4, wherein the step of filling the remainder of the trench (110) with a shield electrode material (118) comprises filling said remainder with a polysilicon material.

6. The method of any of claims 1-5, wherein the step of forming the gate electrode (124) comprises depositing a polysilicon material in between the inter electrode dielectric r (122) and the exposed portion of the gate dielectric (112).

7. The method of any of claims 1-6, wherein the gate dielectric (112) is a gate oxide liner.

8. The method of any of claims 1-7, further comprising thickening the gate dielectric (112) after the removal of the etch protection layer (114) to the first depth from said trench.

9. The method of any of claims 1-8, wherein the step of forming the inter electrode dielectric (122) on the exposed shield electrode material comprises growing an oxide layer over said top portion.

10. A vertical transistor comprising:
a substrate (100) including a vertical stack of regions including a source region (102) separated from a drain region (106) by a channel region (104) and a trench lined with a gate dielectric (112), said trench at least partially extending through said vertical stack of regions, wherein said trench comprises a shield electrode (118') and a gate electrode (124) surrounding an upper portion of the shield electrode, and being laterally separated from the upper portion by an inter electrode dielectric (122) covering said portion, and wherein the remainder of the shield electrode is laterally separated from the gate dielectric by a further insulating layer (116) and an etch protection layer (114) between the gate dielectric and the further insulating layer.

11. The vertical transistor of claim 10, wherein the etch protection layer (114) is a nitride layer.

12. The vertical transistor of claim 10 or 11, wherein the gate dielectric (112) is a gate oxide.

13. The vertical transistor of any of claims 10-12, wherein the further insulating layer (116) is an oxide layer.

14. The vertical transistor of any of claims 10-13, wherein at least one of the shield electrode (118') and the gate electrode (124) comprises polysilicon.

15. A semiconductor device comprising the vertical transistor of any of claims 10-14.
